# EUROPEAN PATENT APPLICATION

(11) **EP 0 673 900 A2**
(43) Date of publication of application: **27.09.1995**
(21) Application number: 95104171.4
(22) Date of filing: 22.03.1995
(51) Int. Cl.: C04B 35/83

(54) **Carbon/carbon composites and electrical apparatus containing the same**

(30) Priority: 25.03.1994 US 218208
(71) Applicant: THE B.F. GOODRICH COMPANY, Akron Ohio 44313-1799 (US)
(72) Inventor: Shih, Wei-Teh, Yorba Linda, California 92686 (US)
(74) Representative: Weber, Thomas, Dr.Dipl.-Chem.

(57) **Abstract**

This invention relates to a carbon-carbon composite prepared by partially densifying a carbon fiber preform with a carbon matrix to form a densified carbon composite, and infiltrating the densified carbon composite with at least one material capable of increasing the coefficient of thermal expansion of the carbon composite. The invention also relates to apparatus containing the carbon-carbon composites. These carbon-carbon composites have beneficial coefficients of thermal expansion and good thermal conductivity.

## Description

### FIELD OF THE INVENTION

This invention relates to carbon-carbon composites and electrical apparatus containing the same. The carbon-carbon composites contain a material capable of increasing the thermal coefficient of expansion of the carbon composites.

### BACKGROUND OF THE INVENTION

The major problem with electronic packaging is thermal management. As electronic devices are reduced in size, the need to remove heat becomes critical. This is especially true with computer chips such as the new more powerful chips and with multiple chip modules (MCM). As the power of the chips is increased and their sized reduced, the need to remove heat is important for good performance.

As another aspect of chip design, the chips are placed as close as possible on the chip carrier. As the thermal energy accumulates, the component and the junction temperatures begin to rise. The increased shear strain at the solder joints is directly proportional to the change in the coefficient of thermal expansion (CTE) and change in the temperature of the jointed materials. High shear strains at the solder joints tend to cause solder joint failures and reduce the reliability of the electronic packaging.

It is desirable to have a material as a thermal spreader and/or heat sink with good thermal conductivity and which closely approximates the coefficient of thermal expansion of the chip and chip substrate.

### SUMMARY OF THE INVENTION

This invention relates to a carbon-carbon composite prepared by partially densifying a carbon fiber preform with a carbon matrix to form a densified carbon composite, and infiltrating the densified carbon composite with at least one material capable of increasing the coefficient of thermal expansion of the carbon composite. The invention also relates to apparatus containing the carbon-carbon composites. These carbon-carbon composite have beneficial coefficients of thermal expansion and good thermal conductivity.

### BRIEF DESCRIPTION OF THE DRAWINGS

Fig. 1 is a cross section of MCM, multiple chip module, using thin film circuitry,
Fig. 2 is a cross section of a MCM, using a PWB, printed wiring board, and
Fig. 3 is a cross section of a MCM, using a ceramic substrate.

### DETAILED DESCRIPTION OF THE PREFERRED EMBODIMENTS

As used in the specification and the attached claims, CVI refers to chemical vapor infiltration; CVD refers to chemical vapor deposition; and isotropic carbon composites refers to carbon composites with approximately equal properties in each direction. A thermal spreader acts to carry heat away from electronic devices such as computer chips. An example of a thermal spreader is a thermal plane.

As described above the present invention relates to carbon-carbon composites which are prepared by partially densifying a carbon fiber preform with a carbon matrix and then infiltrating the densified carbon composite with a material capable of increasing the thermal coefficient of thermal expansion of the densified carbon composite. The density of the densified carbon composite is from about 0.75 to about 1.8, or from about 1.0 to about 1.7, or from about 1.1 to about 1.6 g/cc. The densified carbon-carbon composite is heated to graphitize the carbon. The graphitization improves the thermal conductivity of the carbon composite. The temperature is typically from about 2000°C to about 4000°C, or from about 2300°C to about 3500°C, or from about 2500°C to about 3100°C. The graphitization typically is accomplished in about 0.5 to about 5 hours.

As described above the carbon-carbon composites are prepared by densifying a carbon fiber preform with a carbon matrix. The carbon fiber preform may be prepared from any fiber which may form carbon or graphite upon heating. The fibers include PAN (polyacrylonitrile) fibers, pre-oxidized acrylonitrile resin fibers, pitch fibers, CVD carbon fibers, pyrolyzed natural fibers, such as pyrolyzed cotton fibers, and mixtures thereof. The fibers are arranged to form the carbon fiber preform in a manner known to those in the art. The preforms may be woven or nonwoven. The preforms may be formed from braided fibers, typically straight braided fibers. Braided fibers are described in U.S. Patent 5,217,770, issued to Morris, Jr, et al. The carbon fiber preform may be 1D (one dimensional), 2D (two dimensional), needled 2D, or 3D (three dimensional).

The carbon fiber preform is densified in the presence of a carbon matrix. The carbon matrix supplies a source of carbon which may be converted to graphite. The carbon matrix is introduced to the carbon fiber preform by chemical vapor infiltration (CVI) or by pitch impregnation. The carbon matrix comprises CVI carbon, a pyrolyzable carbon source, such as methane or pitch, or mixtures thereof.

The partially densified carbon composite is thereafter infiltrated with one or more materials capable of increasing the coefficient of thermal expansion of the densified carbon composites. The material fills the voids in the carbon composite. Preferably the voids are interconnected. The materials which improve the coefficient of thermal expansion are generally present in an amount from about 5% up to about 60%, or from about 7% up to about 40%, or from about 10% up to about 25% by volume. One advantage of the present method is that if the coefficient of thermal expansion between the carbon-carbon composites and the electronic substrate and electronic devices are equal or nearly equal, then solder may be used to attach the components. The matching of the coefficient of thermal expansion reduces thermal stress and provides reliable electronic devices. Solder is beneficial because it has improved thermal conductive properties.

The materials include at least one polymer, ceramic, or metal. The polymers include epoxy polymers, polyimides, isocyanate esters and other thermoset and thermoplastic polymers capable of increasing the coefficient of thermal expansion. The ceramics which are useful include alumina, aluminum nitride, silicon carbide, silicon nitride, boron carbide, boron nitride, and mixtures thereof and ceramic precursors, such as polycarbosilane. For example, a carbon composite may be infiltrated with silicon carbide by CVI.

In one embodiment, the materials capable of raising the coefficient of thermal expansion of the densified carbon composite include metals and metal alloys. Specific examples include, aluminum, aluminum silicon (40%), copper, copper and tungsten (40% copper) alloy, copper molybdenum (15%) alloy, molybdenum, silver, nickel, and iron and tungsten. In one embodiment, the metals include aluminum, copper, silver and mixtures and alloys thereof. For example, the metal or metal alloys may be infiltrated into a carbon deposit by first pulling a vacuum on the carbon composite and degassing the composite. The metal or metal alloy is then heated to at or near its melting point and infiltrated into the carbon composite under pressure.

The following examples relate to above carbon-carbon composites. Unless otherwise indicated here as well as elsewhere in the specification and claims, the weight and ratios are by volume, the temperature is in degrees Celsius and the pressure is atmospheric.

A needled PAN fiber carbon preforms were processed by CVD to the densities given below, and then heat treated to 3000°C until the carbon matrix was graphitized. The densified carbon composites were infiltrated with either aluminum or copper by a process, which is believed to be pressure infiltration, of Amercom Inc. of Chatsworth, California. The coefficient of thermal expansion and thermal conductivity were measured and given below.

The coefficient of thermal expansion were measured by a dilatometer in a DMA machine from DuPont Chemical Company. Thermal conductivity were measured by laser pulsed thermal diffusivity.

**Table 1**

| Properties of Aluminum Impregnated Composites | | | | | | | | |
|---|---|---|---|---|---|---|---|---|
| | C-C Density gm/cc | Final Density gm/cc | CTE ppm/K X Y Z | | | Thermal Conductivity watt/m.K X Y Z | | |
| Al-1 | 0.968 | 2.299 | 10.2 | 11.1 | 14.4 | na | 164 | 197 |
| Al-2 | 1.475 | 2.235 | 6.05 | 7.25 | na | 279 | 252 | 229 |
| Al-3 | 1.495 | 2.180 | 4.42 | 3.44 | na | 254 | 277 | 291 |
| Al-4 | 1.529 | 2.173 | 4.54 | 4.07 | 2.07 | 262 | 315 | 273 |

**Table 2**

| Properties of Copper Impregnated Composites | | | | | | | | |
|---|---|---|---|---|---|---|---|---|
| | C-C Density gm/cc | Final Density gm/cc | CTE ppm/K X Y Z | | | Thermal Conductivity watt/m.K X Y Z | | |
| Cu-1 | 0.968 | 5.109 | 12.9 | 8.6 | 11.9 | 213 | 135 | 143 |
| Cu-2 | 1.475 | 4.33 | 4.75 | 5.7 | 9.99 | 293 | 333 | 235 |
| Cu-3 | 1.495 | 3.585 | 5.64 | na | 3.16 | 217 | 222 | 137 |
| Cu-4 | 1.529 | 3.130 | 2.45 | 2.97 | 3.43 | 280 | 271 | 290 |

In another embodiment, the present invention relates to an apparatus comprising at least one electronic device connected to an electronic substrate and a carbon-carbon composite connected to the electronic substrate, wherein the carbon-carbon composite is described above. The electronic devices include computer chips, capacitors, circuitry, etc. The electronic substrate include those used to support the electronic devices. In one aspect, the electronic substrate is an electronic chip substrates or printed circuit board substrates. Examples of electronic substrates includes fiberglass-epoxy substrates and ceramic substrates, such as aluminum nitride, beryllium oxide, silicon carbide, silicon, alumina, gallium arsenide, etc.

The electronic devices are mounted on the electronic substrates by means known to those in the art. The carbon-carbon deposits of the present invention are used as thermal spreaders and heat sinks. The carbon-carbon deposit is connected to the electronic substrates and preferably are connected with the bond line having a thickness of 1 to about 5 mil. Preferably, the bond line is a constant bond line. Typically, the devices and carbon-carbon composites may be mounted by solder, metal flux, or a polymer adhesive, such as a silicon-based adhesive. In one embodiment, the polymer adhesive is a thermal adhesive, having aluminum nitride and silver in an epoxy concentrate. The adhesive is available from A.I. Technology, Trenton, New Jersey.

The above carbon-carbon composites may be used as a thermal spreader which is soldered onto an alumna PWB, printed wiring board; as a substrate for thin film multiple chip modules; as a heat sink for high power electronic computer chips; and as a replacement of Invar/Covar metals.

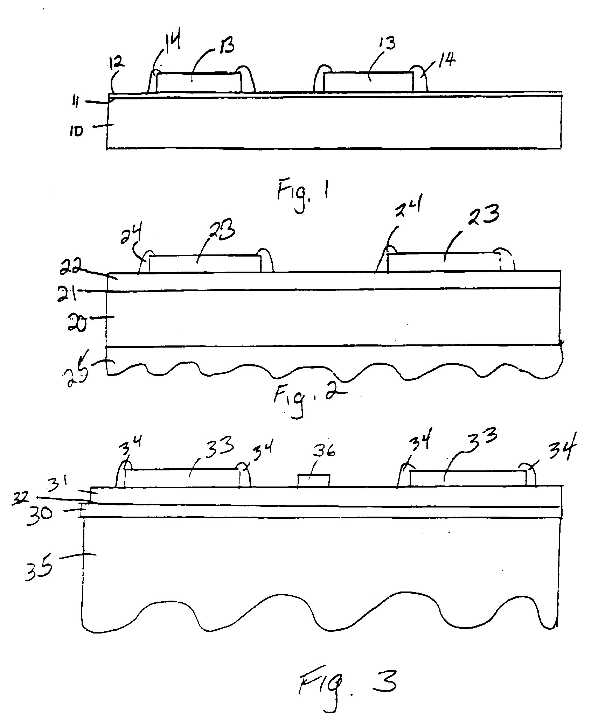

With reference to the drawings, Fig. 1 is a cross section of a MCM, multiple chip module, where the carbon-carbon composite thermal spreader (10) is attached with dielectric layer, such as a polymer or diamond layer, (11) to thin film circuitry (12) and computer chips (13) which are attached by solder (14). Fig. 2 is a cross section of a MCM with the carbon-carbon composite thermal spreader (20) attached with adhesive, solder, or brazing (21) to PWB, printed wiring board (22). PWB (22) is attached to computer chips (23) with solder (24). Optionally, thermal spreader (20) is attached to heat sink (25) with solder, brazing or an adhesive. With respect to Fig. 3, thermal spreader (30) is attached to a ceramic substrates (31) with resin based adhesive, solder or brazing (32). Ceramic substrate (31) is attached computer chips (33) with solder (34) and to filter capacitor (36) with solder. Optionally, the thermal spreader (30) is attached to heat sink (35) with solder, brazing, or an adhesive.

While the invention has been explained in relation to its preferred embodiments, it is to be understood that various modifications thereof will become apparent to those skilled in the art upon reading the specification. Therefore, it is to be understood that the invention disclosed herein is intended to cover such modifications as fall within the scope of the appended claims.

## Claims

1. A carbon-carbon composite prepared by partially densifying a carbon fiber preform with a carbon matrix to form a densified carbon composite, and infiltrating the densified carbon composite with at least one material capable of increasing the coefficient of thermal expansion of the carbon composite.

2. The carbon composite of claim 1 wherein the carbon composite has a density from about 0.75 to about 1.8 g/cc before infiltration.

3. The carbon composite of claim 1 wherein carbon fiber preform is prepared fibers selected from the group consisting of polyacrylonitrile fibers, pitch fibers, CVD carbon fibers, pyrolyzed natural fibers and mixtures thereof.

4. The carbon composite of claim 1 wherein the carbon fiber preform is woven or nonwoven.

5. The carbon composite of claim 1 wherein the carbon fiber preforms formed from braided fibers.

6. The carbon composite of claim 1 wherein the carbon fiber preform is a 1D, 2D, or 3D carbon fiber preform.

7. The carbon composite of claim 1 wherein the carbon preform is needled 2D or 3D carbon fiber preform.

8. The composite of claims 1 wherein the carbon matrix is CVI carbon, a graphitizable carbon source or mixtures thereof.

9. The composite of claim 1 wherein the material comprises at least one polymer, ceramic, or metal.

10. The composite of claim 1 wherein the material is a polymer selected from epoxy polymers, polyimides and mixtures thereof.

11. The composite of claim 1 wherein the material is a ceramic selected from the group consisting of silicon carbide, boron carbide, aluminum nitride, or mixtures thereof.

12. The composite of claim 1 wherein the material is selected from the group consisting of aluminum, copper, silver and mixtures and alloys thereof.

13. The carbon composite of claim 1 wherein the material is present in an amount from about 5% up to about 60% by volume.

14. The carbon composite of claim 1 wherein the densified carbon composite is heated to at least about 2000°C to improve thermal conductivity.

15. A carbon-carbon composite prepared by partially densifying a carbon fiber preform with a carbon matrix to form a densified carbon composite having a density from about 1.0 to about 1.8 g/cc, and infiltrating the densified carbon composite with from about 5% to about 60% by volume of a metal selected from the group consisting of aluminum, copper, silver and mixtures and alloys thereof.

16. The carbon composite of claim 15 wherein the carbon preform is needled 2D or 3D carbon fiber preform.

17. The carbon composite of claim 15 wherein the densified carbon composite is heated to at least about 2000°C to improve thermal conductivity.

18. An apparatus comprising at least one electronic device connected to an electronic substrate and a carbon-carbon composite connected to the electronic substrate, wherein the carbon-carbon composite is prepared by partially densifying a carbon fiber preform with a carbon matrix to form a densified carbon composite, and infiltrating the densified carbon composite with at least one material capable of increasing the coefficient of thermal expansion of the carbon composite.

19. The apparatus of claim 18 wherein the electronic substrate is a electronic circuitry printed wiring board.

20. The apparatus of claim 18 wherein the electronic device is a computer chip or a capacitor.
